# EUROPEAN PATENT SPECIFICATION

(11) **EP 3 670 698 B1**
(45) Date of publication and mention of the grant of the patent: **11.08.2021**
(21) Application number: 18212914.8
(22) Date of filing: 17.12.2018
(51) Int. Cl.: C23C 18/18, C23C 18/20, C23C 18/40

(54) **AQUEOUS ALKALINE PRE-TREATMENT SOLUTION FOR USE PRIOR TO DEPOSITION OF A PALLADIUM ACTIVATION LAYER, METHOD AND USE THEREOF**
WÄSSRIGE ALKALISCHE VORBEHANDLUNGSLÖSUNG ZUR VERWENDUNG VOR DER ABLAGERUNG EINER PALLADIUMAKTIVIERUNGSSCHICHT, VERFAHREN UND VERWENDUNG DAVON
SOLUTION DE PRÉTRAITEMENT ALCALIN AQUEUX À UTILISER AVANT LE DÉPÔT D'UNE COUCHE D'ACTIVATION DE PALLADIUM, SON PROCÉDÉ ET SON UTILISATION

(43) Date of publication of application: 24.06.2020
(73) Proprietor: Atotech Deutschland GmbH, 10553 Berlin (DE)
(72) Inventor: Bremmert, Stefanie, 10553 Berlin (DE); Gernhard, Marius, Berlin (DE); Gregoriades, Dr. Laurence John, 10553 Berlin (DE); Wurdinger, Kay, 10553 Berlin (DE)
(74) Representative: Atotech Deutschland GmbH

(56) References cited:
- JP-A- H0 426 771
- KR-B1- 101 681 116
- US-A1- 2007 110 973
- US-A1- 2010 143 730
- US-A1- 2011 259 373

## Description

### Field of the Invention

The present invention relates to a novel aqueous alkaline pre-treatment solution for use prior to deposition of a palladium activation layer on a substrate in manufacturing an article with an integrated circuit and a method thereof, in particular the solution and the method can be used for desmear and metallization (for printed through-holes) process step for high-density interconnect (HDI) and package substrate applications, more particularly for metallization of substrates having conductive and nonconductive surfaces for the manufacturing of printed circuit boards, especially of multilayer boards (MLB) and fine line HDI boards wherein circuit features as blind microvias (BMVs), through-holes or interconnects can be produced.

### Background of the Invention

Conventional printed circuit boards (PCBs) comprise laminated non-conductive dielectric substrates that rely on drilled and plated through holes (PTHs) to form a connection between the opposite sides and/or inner layers of a board. Electroless plating is a well-known process for preparing metallic coatings on surfaces. Electroless plating on a dielectric surface requires the prior deposition of a catalyst.

Commonly used methods to catalyse or activate laminated non-conductive dielectric substrate regions, prior to electroless plating, include treatment of the board with an aqueous tin-palladium colloid in an acidic chloride medium or treatment with an alkaline ionic palladium solution followed by reduction with an appropriate reducing agent. The aforementioned colloid consists of a metallic palladium core surrounded by a stabilizing layer of tin (II) ions. A shell of [SnCl3]-complexes acts as surface stabilizing groups to avoid agglomeration of colloids in suspension. The aforementioned ionic palladium solution comprises a palladium salt as well as a suitable ligand and the reduction of the ionic palladium therein can be accomplished by a reducing agent based on borane.

There are many factors affecting the performance of the catalytic methods mentioned above. Colloidal palladium activators are sensitive to oxidation while ionic palladium activators can be impaired in their function by the dragging-in of components contained in preceding treatment solutions. For example, copper ions dragged into typical ionic palladium activation solutions tend to precipitate as hydrated copper oxides or as copper hydroxide.

Prior to the treatment of the substrate with an alkaline ionic palladium catalyst, the substrate is typically immersed in an acidic bath. Following this treatment, the substrate is then treated directly with the alkaline ionic palladium catalyst, without implementing an intermediate rinsing of the substrate. Thus, acidic pre dip treatment solution is directly dragged into the alkaline ionic palladium solution, which can result in the undesirable precipitation of hydrated palladium oxides or palladium hydroxide.

The aforementioned acidic pre dip treatment solutions typically contain surfactants and can therefore be prone to foaming. Substrate activation by the aforementioned alkaline ionic palladium catalyst method, which is preceded by treatment with such acidic pre dip treatment solutions, can lead to the formation of an unspecific palladium layer on the substrate, which can then lead to incomplete copper etching in the subsequent processes and therefore to short circuits. As electronics industry constantly demands improved quality and reliability in the manufacturing of high density interconnect (HDI) boards and multilayer boards (MLB) due to continuing miniaturisation of board features such as blind microvias (BMVs) and conductive tracks, there is a desire to minimise the risk of formation of such short circuits. In addition, due to permanent changing of substrate materials with new properties there is also a demand of excellent coverage performance on various different substrates.

JPH0426771A relates to a pretreatment liquid for electroless plating, more particularly to a pretreatment liquid for electroless copper plating of a printed wiring board. The pretreatment liquid for electroless plating comprising a surfactant, a surfactant containing a metal complexing agent and an alkaline aqueous solution of pH 10 or more containing an ammonium alkyl polymethacrylate.

### Objectives of the Invention

Therefore, it is an object of the present invention to overcome shortcomings of the prior art and to provide means for improved subsequent deposition of a palladium activation layer on a substrate.

It is a further object of the present invention to improve the adsorption of the palladium layer onto a wide variety of substrate materials, especially on the glass component of composite substrates comprising organic polymers and glass.

It is still another object of the present invention to use the means for fine line HDI, MLB and packages substrates.

It is still another object to improve the yield of well-treated substrates by robust activation and reduce short circuits, especially palladium-triggered short-circuits.

It is still another object to reduce the amount of hydrated palladium oxides or palladium hydroxide precipitated in alkaline ionic palladium catalysts.

It is still another object to ensure that foaming is reduced in alkaline ionic palladium catalysts.

### Summary of the Invention

These objectives are solved with the present invention.

In one aspect of the present invention, an aqueous alkaline pre-treatment solution is provided for use prior to the deposition of a palladium activation layer on a substrate in manufacturing an article with an integrated circuit comprising:
- at least one hydroxycarboxylic acid or salt thereof according to the general formula (I)

   [RCH₂-(RCH)ₙ-COO⁻]ₘ M^{m+} (I)

   wherein n is an integer from 2 to 4 and m is 1 or 2,
   R is independently H or OH with proviso that at least one R is OH, and wherein M^{m+} with m: 1 is hydrogen, ammonium, or alkali metal; or M^{m+} with m: 2 is earth alkali metal, wherein the concentration of the at least one hydroxycarboxylic acid or salt thereof is from 200 to 400 mg/L,
- at least one polyoxyethylene sorbitan fatty acid ester, wherein the concentration of the at least one polyoxyethylene sorbitan fatty acid ester is from 0.4 to 1.2 mg/L,
- at least one sulphonated fatty acid or a salt thereof, wherein the concentration of the at least one sulphonated fatty acid is from 4 to 12 mg/L.

In another aspect of the present invention, a method for pre-treatment of a substrate is provided for subsequent deposition of a palladium activation layer on said substrate in manufacturing an article with an integrated circuit comprising the following steps in the given order:
(i) providing the substrate having at least one conductive metal layer surface and at least one non-conductive surface;
(ii) providing the aqueous pre-treatment solution according to the inventive solution above;
(iii) treating the substrate with the pre-treatment solution by bringing the substrate into contact with the aqueous pre-treatment solution.

In still another aspect of the present invention, the use of the aqueous pre-treatment solution above is provided for subsequent deposition of a palladium ion layer on a substrate in manufacturing an article with an integrated circuit wherein the solution is directly applied before applying a palladium activation solution in order to minimize a palladium particle formation while forming the palladium ion layer. "Directly" in this context means that no further treatment steps, e.g. rinsing steps, are performed in between.

In still another aspect of the invention, the use of the aqueous pre-treatment solution or the method according to the invention is provided for subsequent deposition of a metal layer in manufacturing an article with an integrated circuit and in particular for metallisation of at least one recessed structure of the at least one non-conductive surface in manufacturing an article with an integrated circuit as metal filled through holes, blind via or conducting lines.

In particular the invention leads to a significant reduction in particle formation thereby enabling higher yield rates in the production of electronic article as HDI and MLB boards with fine features wherein lines and spaces (L/S) can be reduced to 75/75 or up to 25/25 µm and e.g. for horizontal applications to aspect ratios of through hole of about 1:3 to about 1:10 and blind holes of about 1:1 or up to 1:1.15 - 1:2.3. For vertical plating applications aspect ratios of through hole of about 1:3 to about 1:30 are possible. At the same time, the process provides excellent coverage performance while significantly reducing foaming behavior.

Furthermore the invention provides a stable performance of the palladium activation solution over the life time because the activator performance of the subsequent used palladium activation solution is not impaired due to drag in of disturbing amounts of compounds of the pre-treatment solution as solved copper ions.

With the present invention it could be also shown, that also electrical reliability after so-called solder shock test can fulfill the industrial requirements of the electronics industry over existing solutions from the state of the art. Additionally it could be shown that during using the inventive aqueous alkaline solution over time up to end of lifetime, the results of the electrical reliability test even rose.

The invention can be used in a wide range of different base materials of different suppliers.

The substrate that can be used in the present invention is preferably a non-conductive substrate having at least one non-conductive surface, wherein the at least one non-conductive surface is part of the non-conductive substrate and consequently made of the same material as the non-conductive substrate, and having at least one conductive metal layer surface. Combinations of conductive metal surfaces and non-conductive surfaces can be found for example in printed circuit boards when they are positioned adjacent to each other.

The non-conductive substrate is preferably selected from glass, silicon, resins and plastics, as well as mixtures and blends thereof. Resins and plastics include dielectric materials typically used in the electronics industry and materials typically used in the manufacturing of household goods which are to be metallized. Resins and plastics are preferably selected from epoxy, polyester such as polyethylene terephthalate (PET), polyimide (PI), polytetrafluorethylene, acrylonitrile-butadiene-styrene (ABS) copolymer, polyamide (PA), polycarbonate (PC) as well as mixtures and blends of the aforementioned.

Suitable glass is preferably selected from borosilicate glass, quartz glass, silica glass, fluorinated glass. Silicon preferably includes polysilicon (including doped polysilicon such as p doped polysilicon and n-doped polysilicon) and monocrystalline silicon, silicon oxide, silicon nitride as well as silicon oxynitride.

The non-conductive substrate more preferably comprises polyimide resins or epoxy resins. The polyimide resins can be modified by the addition of polysiloxane, polycarbonate, polyester or the like. The epoxy resins can be glass epoxy board material comprising a combination of the epoxy resin and glass fiber, or the same modified to have a low thermal expansion and a high glass-transition temperature, constituting a high glass-transition temperature glass epoxy board material.

The at least one non-conductive surface of the non-conductive substrate has at least one recessed structure. Such recessed structures are preferably selected from the group consisting of trenches, blind micro vias (BMVs), through hole vias (THVs), through glass vias (TGVs), through silicon vias (TSVs), buried vias (or those vias which are to become such buried vias during later stages of the manufacturing process) and mixtures of any of the aforementioned, more preferably the recessed structures are one of the aforementioned vias or mixtures of these vias. Mostly, such a substrate comprises a plurality of said recessed structures. By choosing said substrates in the process according to the invention, the named recessed structures are preferably used as surfaces in the process according to the invention.

The conductive metal layer surface can be formed by e.g. integrated conductive structures/pattern as interconnects, filled microvias or blind microvias, and lines within the substrate which at least end up at the surface of the substrate (already existing structures before applying the invention). The conductive metal layer surface is preferably selected from copper, tungsten, tantalum, nickel, cobalt, gold as well as alloys and mixtures of the aforementioned. Said preferred metals, alloys and mixtures of the aforementioned are widely used in the electronics industry. More preferred are copper and copper alloys because their superior conductivity makes them particularly useful in the electronics industry. Most preferably the conductive metal layer surface consists of copper.

Due to the preceding steps before step i) of the inventive method, etching steps and cleaning steps can be conducted in providing a substrate having at least one conductive metal layer surface as copper and at least one non-conductive surface, wherein the conductive metal layer surface may comprise metal oxides, in particular copper oxide, after these preceding steps.

In one embodiment of the present invention the substrate is a heat-resistant glass cloth substrate epoxy resin copper-clad laminated board material wherein the copper cladding forms at least partly or completely the conductive metal layer surface. The copper cladding may comprise copper oxides.

The substrate is made in its entirety of any of the listed materials or combinations thereof or it only comprises surfaces made of one or more of the materials listed (above). Accordingly, the substrate can be selected from the group consisting of printed circuit board substrates, circuit carrier substrates, interconnect devices substrates and precursors for any of the aforementioned for manufacturing of the article. Such precursors include inter alia FR-1, FR-2, FR-3, FR-4, FR-5, copper-clad materials and laminates thereof.

Preferably the conductive metal layer of the metal layer surface, preferably a copper layer, has a thickness of several tens of nm to several tens of µm, more preferably has a thickness of 0.1 to 1.5 µm, most preferably 0.2 to 1 µm. The conductive metal layer can be formed by bonding a copper foil onto the substrate by means of a bonding agent, or the metal layer can be formed by means of a dry method or a wet method such as sputtering or vapour deposition followed by copper electroplating, or those comprising e.g. a thermoplastic polyimide resin and a copper layer laminated together, or those in which a single or multiple types of polyimide resin have been flow-casting laminated onto a copper layer.

The invention is preferably directed to the so-called plating through holes process in manufacturing the articles and is particularly aimed at forming a metal layer on the non-conductive surfaces within the recessed structures as vias like blind micro vias (BMVs), through hole vias (THVs), through glass vias (TGVs), through silicon vias (TSVs), buried vias which can be formed prior by drilling processes as laser drilling or mechanical drilling processes.

The invention ensures especially within the through hole proper wetting, pre-conditions the substrate and securely removes remaining copper oxides after etch cleaning. In particular the coverage on glass/resin comprising substrates is improved.

Preferably, the method according to the invention is directed to the manufacturing of an article as a printed circuit board for high-density interconnect (HDI) and package substrate applications, more particularly for metallization of substrates having conductive and nonconductive surfaces for the manufacturing of articles as printed circuit boards, especially of multilayer boards (MLB) and fine line HDI boards.

The concentration of the at least one hydroxycarboxylic acid or a salt thereof according to the invention is from 200 to 400 mg/L. Preferably the concentration is from 260 to 370 mg/L, more preferably from 280 to 350 mg/L. In case that more than one hydroxycarboxylic acid or salt thereof is used, the total amount of the used hydroxycarboxylic acid or salt thereof is within the said concentration.

Preferably the at least one hydroxycarboxylic acid or the salt thereof according to the general formula (I)

[RCH₂-(RCH)ₙ-COO⁻]ₘ M^{m+} (I)

has an integer n of 4. More preferably all R are OH and n is 4. In another preferred embodiment all R are OH, n is 4 and wherein m is 1 and M^{m+} is hydrogen, sodium, potassium or wherein m is 2 and M^{m+} is magnesium, calcium. Most preferably the at least one hydroxycarboxylic acid or the salt thereof is gluconic acid or sodium gluconate.

With the preferred concentration of the hydroxycarboxylic acid or a salt thereof, soluble copper ions e.g. of the copper oxide can be complexed while palladium ions of the subsequent deposition of a palladium activation layer will not be complexed.

The concentration of the at least one polyoxyethylene sorbitan fatty acid ester according to the invention is from 0.4 to 1.2 mg/L, preferably from 0.6 to 0.9 mg/L. In case that more than one polyoxyethylene sorbitan fatty acid ester is used, the total amount of the used polyoxyethylene sorbitan fatty acid ester is within the said concentration. If polyoxyethylene sorbitan fatty acid ester is mentioned, also derivatives of the polyoxyethylene sorbitan fatty acid ester are included having functional groups as halogens, hydroxyl etc. which replace hydrogen. In a preferred embodiment the fatty acid ester are selected from a group consisting of monolaurate, monopalmitate, monopalmitoleate monostearate, monooleate, tristearate or trioleate.

The concentration of the at least one sulphonated fatty acid or salt thereof according to the invention is from 4 to 12 mg/L, preferably from 5 to 10 mg/L, more preferably from 6 to 9 mg/L. In case that more than one sulphonated fatty acid or salt thereof is used, the total amount of the used sulphonated fatty acid or salt thereof is within the said concentration. Preferably the at least one sulphonated fatty acid is selected from the group consisting of unsaturated branched or unbranched C16 to C20 fatty acids or mixtures thereof, more preferably the at least one sulphonated fatty acid is an saturated or unsaturated unbranched C16 to C20 fatty acids. In a preferred embodiment the fatty acid ester of the sulphonated fatty acid are selected from a group consisting of lauric acid, palmitic acid, palmitoleic acid, stearic acid, oleic acid or arachidic acid.

The aqueous alkaline pre-treatment solution according to the invention has a suitable pH range from 8 - 12, preferably from 9.5 to 11.5. The pH value can be adjusted by adding one or more inorganic base, e.g. sodium hydroxide, potassium hydroxide. Additionally organic base can be added.

The method according to the invention is used for subsequent deposition of a palladium activation layer by a palladium activation solution on a substrate, especially for glass epoxy board material substrates.

The method is preferably used in horizontal plating equipment, wherein the substrate is conveyed by a transport device to be processed through the treatment modules of the plating equipment. The substrate, e.g. a board-shaped work piece, is held in a horizontal orientation. The transport device preferably uses transport rolls or transport clamps for transporting the substrate in its horizontal orientation.

After the substrate is treated with the aqueous alkaline pre-treatment solution in step (iii) the substrate is preferably directly treated (without further treatment steps as a cleaning or rinsing step) in treatment step (iv) treating the substrate with a palladium activation solution wherein a palladium ion layer is deposited onto the surfaces of the treated substrate of step (iii). By treating the substrate directly after treatment step (iii) it could be found that the performance of the palladium activation solution is stabilized over the life time because the activator performance of the subsequent used palladium activation solution is not impaired due to drag in of disturbing amounts of compounds of the pre-treatment solution as solved copper ions.

The palladium activation solution comprises at least one source of palladium ions. Additionally the solution may comprise other sources of metal ions, as sources of ruthenium ions, sources of rhodium ions, sources of palladium ions, sources of osmium ions, sources of iridium ions, sources of platinum ions, sources of copper ions, sources of silver ions, sources of nickel ions, sources of cobalt ions, sources of gold ions and mixtures thereof. The palladium ions and said additional metal ions are being adsorbed on the surface of said substrate.

Subsequently, treating the surface of substrate comprising at least the palladium ions (iv) a further treatment step (v) is conducted in treating the substrate with a solution comprising at least one reducing agent suitable to reduce the metal ions (at least the palladium ions) adsorbed on the surface of said substrate selected from the group consisting of boron based reducing agents, sources of hypophosphite ions, hydrazine and hydrazine derivatives, ascorbic acid, iso-ascorbic acid, sources of formaldehyde, glyoxylic acid, sources of glyoxylic acid, glycolic acid, formic acid, sugars, and salts of aforementioned acids.

By treating the substrate obtained from step (iv), wherein the palladium ion layer is preferably deposited solely onto the at least one non-conductive surface, at least one portion of the metal ions adsorbed thereon is reduced, preferably to the respective metallic state. Step (v) is herein also referred to as "reduction step".

The aqueous alkaline pre-treatment solution and the method according to the invention for pre-treatment of a substrate for subsequent deposition of a palladium layer on a substrate is used further for subsequent deposition of a metal layer in manufacturing an article with an integrated circuit as a printed circuit board.

The deposition is provided by treating the surface obtained from step (v) of said substrate with a treatment step (vi) for treating the substrate with a metallizing solution comprising a solvent and at least one source of metal ions to be deposited such that a metal or metal alloy is deposited thereon. Step (vi) is herein also referred to as "metallization step".

The metallizing solution (also referred to as plating bath) is selected to be an electroless metallising solution, an electrolytic metallizing solution or an immersion metallizing solution.

Preferably, the metallizing solution is an electroless metallizing solution because this will most effectively form a metal or metal alloy layer on the surface obtained from step (v). Generally, the metallizing solution comprises a solvent, typically water, and at least one source of metal ions to be deposited. Further optional components are complexing agents (or chelating agents) for said metal ions (e.g. those mentioned below), reducing agents for said metal ions, stabilizing agents, co-solvents, wetting agents and functional additives such as brighteners, accelerators, suppressors, anti-tarnish agents. Such metallizing solutions and components are known in the art. The at least one source of metal ions in the electroless metallizing solution is preferably selected from the group consisting of sources of copper ions, sources of nickel ions, sources of cobalt ions and mixtures thereof, more preferably sources of copper ions because of the high conductivity of copper deposits rendering copper or copper alloys particularly useful for the use in the electronics industry.

Contrary to electrolytic metal deposition methods using an external source of electrons, electroless processes are known for the formation of metallic films of many metals. Electroless plating is the controlled autocatalytic deposition of a continuous film of metal without the assistance of an external supply of electrons instead employing (chemical) reducing agents. In the context of the present invention, electroless plating is to be understood as autocatalytic deposition with the aid of a (chemical) reducing agent (referred to as "reducing agent" herein). A further form of metal deposition is immersion plating.

Suitable solutions for palladium activation solution, palladium reduction solution and electroless copper solution are known to the public and can be purchased e.g. as Neoganth® U Activator, Neoganth® P WA or Printoganth® U Plus from Atotech Deutschland GmbH.

### Examples

The invention will now be illustrated by reference to the following non-limiting examples. The relative ratio of the used compounds of the present invention within the examples were found as preferable useful, but are not considered as limiting.

### I. Backlight Test: Investigation of metal or metal alloy coverages of surfaces in recessed structures

The coverage of the surfaces of recessed structures with metal or metal alloy in the process can be assessed using an industry standard Backlight Test, in which a plated coupon is sectioned, so as to allow areas of incomplete coverage to be detected as bright spots when viewed over a strong light source [confer US 2008/0038450 A1]. The quality of the metal or metal alloy deposit is determined by the amount of light that is observed under a conventional optical microscope.

The results of the backlight measurement are given on a scale from D1 to D10, wherein D1 means the worst result and D10 the best result. Reference samples showing results from D1 to D10 are shown in Fig. 3 of WO 2013/050332.

The following substrates as coupons were used in different tests:
Coupons based on the materials DE104, DE117, IS410 and 185 HR (from Isola), R-1755C (from Matsushita / Panasonic), NP140, NP140 TL and NP170 (from Nan Ya), S1141 (from Shengy), KB6160A (from Kingboard) and IT-185-TC (from Iteq) were utilized. The hole diameter in the coupons was 1 mm. If necessary, the substrates were subjected to a desmear and cleaning treatment which is known in the art before applying the solutions of the Inventive Examples or Comparative Examples.

After applying the solutions of the Inventive Examples or Comparative Examples all coupons were used directly in the process described in the following Table I. The substrates were immersed in the given order for the time and temperature as given in Table into the solutions.

**Table I: Process for depositing copper on substrates.**

| Treatment | corresponds to | t [s] | T [°C] |
|---|---|---|---|
| Palladium activation solution Neoganth® U Activator | Step (iv) | 40 | 45 |
| Palladium reduction solution Neoganth® P WA | Step (v) | 30 | 30 |
| Electroless copper solution e.g. Printoganth® U Plus | Step (vi) | 600 | 32 |

Neoganth® U Activator bath
palladium ion concentration: 300 mg/L
- pH: 10

Neoganth P-WA bath
Neoganth P-WA concentration: 6 mL/L
- pH: 8

Electroless copper bath

| | |
|---|---|
| - copper ion concentration: | 2.25 g/L |
| - nickel ion concentration: | 0.5 g/L |
| - Formaldehyde concentration | 4 g/L |
| - NaOH concentration: | 14 g/L |
| - Tartrate concentration: | 19 g/L |
| - cyanide concentration: | 0,006 g/L |

### Inventive Example 1

In the following example, the coupons based of material ISOLA IS410 were tested with different conditions (see Table II) for temperature [°C]/amount [ml] of stock solution/pH value ( e.g. 30/150/10 shows a coverage result of D8.5.)

The coupons were pre-treated with the aqueous alkaline pre-treatment solution of the present invention, wherein 120 mL (Inventive Example 1a), 150 mL (Inventive Example 1b) and 180 mL (Inventive Example 1c) of the stock solutions were provided and diluted with alkaline water to a total volume of 1 L to get the inventive aqueous alkaline pre-treatment solution, and applied according to the conditions of Table II. The stock solution has the following composition and conditions:

### Concentration:

| | |
|---|---|
| Gluconate: | 1,9 g/L |
| polyoxyethylene sorbitan monostearate : | 0.005 g/L |
| Sulphonated monopalmitoleate acid: | 0.046 g/L |
| - Temperature: 35 °C | |
| - pH: 10 | |

The coupons were subsequently treated according to the process in Table I above.

The results of the backlight measurement are given on a scale from D1 to D10, wherein D1 means the worst result and D10 the best result, D7-D10 are desired results.

It can be seen that the pre-treatment solution shows excellent results in the given working ranges according to pH, concentrations and also according to working temperature.

**Table II**

| **Test** | **Coverage results Dx on IS410 Ø: 1.0 mm** |
|---|---|
| **30/150/10** | 8,5 |
| **20/180/11** | 8,1 |
| **20/180/9** | 8,3 |
| **20/150/11** | 8,4 |
| **20/120/10** | 8,3 |
| **20/120/11** | 8,1 |
| **20/150/10** | 8,3 |
| **20/150/9** | 8,1 |
| **20/180/10** | 8,4 |
| **20/120/9** | 7,9 |
| **30/180/10** | 8,4 |
| **30/150/11** | 9,0 |
| **30/180/11** | 8,1 |
| **30/150/9** | 9,3 |
| **30/120/11** | 8,1 |
| **30/180/9** | 8,9 |
| **30/120/10** | 8,1 |
| **30/150/10** | 8,6 |
| **30/120/9** | 8,5 |
| **40/180/10** | 8,7 |
| **40/150/9** | 9,0 |
| **40/150/10** | 8,2 |
| **40/120/10** | 8,2 |
| **40/120/11** | 8,4 |
| **40/120/9** | 8,2 |
| **40/180/9** | 8,3 |
| **40/150/11** | 8,2 |
| **40/180/11** | 8,4 |

### Comparative Example 1

The following different coupons were pre-treated with an aqueous acidic pre-treatment solution of the following composition and conditions:

### Concentration:

| | |
|---|---|
| Sodium bisulfate: | 0.7 g/L |
| PEG 1200: | 0.1 g/L |
| derivative of benzenesulfonic acid: | 0.18 g/L |
| - Temperature: 25 °C | |
| - pH: 3 | |

### Backlight test:

The backlight results are shown in Table III. The copper coverage was evaluated on the basis of the treated coupons. The backlight values were obtained from the backlight coupons. It can be seen, that the present invention is well working over a wide area of different base materials.

**Table III: Backlight values**

| **Test** | **Comparative Example 1** | **Inventive Example 1b** |
|---|---|---|
| Isola 185 HR | 7.0 | 6.1 |
| CEM3 | 6.5 | 6.5 |
| IT-158-TC | 6.3 | 6.3 |
| NP140 | 7.2 | 7.1 |
| S1141 | 7.8 | 6.9 |
| DE117 | 6.5 | 6.2 |
| R1755C | 6.6 | 5.3 |
| NP170 | 6.4 | 7.4 |
| DE104 | 6.1 | 6.9 |
| NP140 TL | 5.5 | 5.5 |
| KB6160A | 5.5 | 5.0 |
| IS410 | 7.6 | 8.0 |

### Comparative Example 2 - 5

The coupons ISOLA IS 410, having hole diameter of 1 mm, were subjected to a desmear and cleaning treatment which is known in the art and were then pre-treated with aqueous pre-treatment solutions of pH 10 containing different additives of the following:
- Comparative Example 2: fatty alcohol polyalkylene glycol ether concentration: 0.015g/L
- Comparative Example 3: Potassium sorbate concentration: 0.02 g/L
- Comparative Example 4: Sulfosalicylic acid: 0.0243 g/L
- Comparative Example 5: PEG 1200 concentration: 0.1g/L

After the pre-treatment step according to the Inventive Example 1b and the Comparative Example 2 - 5 all coupons were treated directly after the pre-treatment step in the same way as described above in Table I.

The backlight results for coupons are summarised in Table IV. The copper coverage was evaluated on the basis of the treated coupons. The backlight values were obtained from the backlight coupons ISOLA IS 410 of Inventive Example 1b and Comparative Examples 2-5.)

**Table IV**

| | Backlight Result |
|---|---|
| Inventive Example 1b | 8,6 |
| Comparative Example 2 - Fatty alcohol polyalkylene glycol ether | 8,3 |
| Comparative Example 3 - Potassium sorbate | 5,6 |
| Comparative Example 4 - Sulfosalicylic acid | 6 |
| Comparative Example 5 - PEG 1200 | 3,9 |

### II. Foaming behavior of pre dip-contaminated activator baths

Following substrate treatment with the so-called pre dip containing the pre-treatment solution, the substrate is directly transferred to the alkaline ionic palladium activation solution without rinsing. Thus, the palladium activation solution is directly contaminated with the components in the pre dip treatment solution.

Table V shows the foaming behaviour of an uncontaminated catalyst treatment solution, a catalyst treatment solution contaminated with pre dip according to the composition described in Comparative Example 1 and a catalyst treatment solution contaminated with pre dip according to the composition described in Inventive Example 1b. It can be seen that the catalyst treatment solution contaminated with pre dip according to the composition described in Inventive Example 1b displays significantly less foam than the catalyst treatment solution contaminated with pre dip according to the composition described in Comparative Example 1, thereby demonstrating the markedly improved foaming characteristics of Inventive Example 1b.

**Table V**

| | |
|---|---|
| Unused palladium activation solution with drag in of 100% water | 5 ml |
| Palladium activation solution with drag in of 100% Inventive Example 1b | 13 ml |
| Palladium activation solution with drag in of 100% Comparative Example 1 | 71 ml |

### III. Particle formation in pre dip-contaminated palladium activation solution

Following the substrate treatment with the pre-treatment solution (pre dip), the substrate is directly transferred to the alkaline ionic palladium catalyst without rinsing. Thus, the catalyst is directly contaminated with the components in the pre dip treatment solution. Table VI depicts the particle formation behaviour of an uncontaminated catalyst treatment solution, a catalyst treatment solution contaminated with pre dip according to the composition described in Comparative Example 1 and a catalyst treatment solution contaminated with pre dip according to the composition described in Inventive Example 1b. It can be seen that the catalyst treatment solution contaminated with pre dip according to the composition described in Inventive Example 1b contains significantly fewer particles than the catalyst treatment solution contaminated with pre dip according to the composition described in Comparative Example 1, thereby demonstrating the markedly improved particle formation characteristics of Inventive Example 1b.

**Table VI**

| **Pre Dip-contaminated activator bath (1:10 diluted)** | **Particle amount/mL** | **Mean size [µm]** | **Standard dev. [µm]** |
|---|---|---|---|
| Comparative example 1 | 168,2 k | 2,719 | 1,03 |
| Inventive example 1b | 68 k | 2,869 | 1,46 |
| "Water-contaminated" for comparison | 34 k | 3,107 | 1,14 |

### IV. Electrical Reliability Test

In order to measure the effect on electrical reliability of a particular treatment solution, the so-called solder shock test, which is known in the art, is often used. In this test, suitable coupons with copper inner layers are desmeared, cleaned, activated, electrolessly plated, electrolytically reinforced and prepared for solder shocking as known in the art. The coupons are then subjected to solder shocking treatment according to the conditions required and examined under a microscope after appropriate sample embedding and cross-section preparation by grinding. The number of interconnect defects (ICDs), that is, the number of separations between the coupon copper inner layers and the deposited copper, are counted while viewing the samples through the microscope: the fewer the ICDs counted, the higher the electrical reliability of the system under investigation.

Table VII contains the solder shock test results of coupons treated with a pre dip solution according to Inventive Example 1b and coupons treated with a pre dip solution according to Comparative Example 1. For the following two tests, the solder bath temperature was used at 288 °C or at 326 °C and the following solder shocking procedure was applied in the given order:
1. Coupon floated on 288 or 326 °C solder surface for 10 s,
2. Coupon removed from 288 or 326 °C solder surface and allowed to cool on a non-conductive surface until room temperature is reached,
3. Coupon turned over and floated a new on 288 or 326 °C solder surface for 10 s,
4. Steps 2 and 3 repeated until coupon floated a total of 6 for 288 °C and 9 times for 326 °C,
5. Embedding and cross-section preparation.

**Table VII**

| **ICDs 6x at 288°C** | | | | | |
|---|---|---|---|---|---|
| **Sample ID** | **Coupon** | | | **Total** | **%** |
| | 1 | 2 | 3 | | |
| Comparative Example 1 | 1/287 | 0/274 | 0/287 | 1/848 | 0,12 |
| Inventive example 1**b** (after make-up) | 0/285 | 9/288 | 0/277 | 9/850 | 1,06 |
| Inventive example 1b (end of lifetime) | 0/255 | 0/262 | 0/261 | 0/778 | 0,00 |
| | | | | | |

| **ICDs 9x at 326°C** | | | | | |
|---|---|---|---|---|---|
| **Sample ID** | **Coupon** | | | **Total** | **%** |
| | 1 | 2 | 3 | | |
| Comparative Example 1 | 36/282 | 41/284 | 28/285 | 105/851 | 12,34 |
| Inventive example 1b (after make-up) | 35/288 | 14/77 | 10/275 | 59/640 | 9,22 |
| Inventive example 1b (end of lifetime) | 0/265 | 1/276 | 1/268 | 2/809 | 0,25 |

It can be seen in Table VII, that the solder shock test performance of Inventive Example 1b is indistinguishable from that of Comparative Example 1 for 288 °C test conditions. According to even harder 326 °C test conditions it can be seen, that electrical reliability of the Inventive Example 1b was slightly better than of the Comparative Example 1 and was improved while running the solution over time.

With the testing of the Inventive Example 1b "real production conditions over time" were simulated, due to the direct drag-in inventive solution into the activator module containing the palladium activation solution. Thereby, the complete amount of the inventive solution plus a certain copper amount is transferred to and located in the palladium activation solution in a minimum of time. In order to simulate this sequence, a complete make-up amount of Inventive Example (150 ml/l) was poured at once into the palladium activation solution. Afterwards 100 ppm copper ions in form of dissolved CᵤSO₄ x 5 H₂O were added and the pH value of the palladium activation solution was adjusted according to the relevant technical data sheet (TDS).

The amount of 100 ppm copper ions refers to the TDS of all conventional pre dip solutions (pre-treatment solutions), wherein this amount of copper ions is set as limit.

## Claims

1. Aqueous alkaline pre-treatment solution for use prior to the deposition of a palladium activation layer on a substrate in manufacturing an article with an integrated circuit comprising:
- at least one hydroxycarboxylic acid or salt thereof according to the general formula (I)
[RCH₂-(RCH)ₙ-COO⁻]ₘ M^{m+} (I)
wherein n is integer from 2 to 4 and m is 1 or 2,
R is independently H or OH with proviso that at least one R is OH, and wherein
M^{m+} with m: 1 is hydrogen, ammonium or alkali metal; or M^{m+} with m: 2 is earth alkali metal, wherein the concentration of the at least one hydroxycarboxylic acid or salt thereof is from 200 to 400 mg/L,
- at least one polyoxyethylene sorbitan fatty acid ester, wherein the concentration of the at least one polyoxyethylene sorbitan fatty acid ester is from 0.4 to 1.2 mg/L,
- at least one sulphonated fatty acid or a salt thereof, wherein the concentration of the at least one sulphonated fatty acid is from 4 to 12 mg/L.

2. Aqueous alkaline pre-treatment solution according to claim 1 wherein the concentration of the at least one hydroxycarboxylic acid or salt thereof is from 260 to 370 mg/L, preferably from 280 to 350 mg/L.

3. Aqueous alkaline pre-treatment solution according to claim 1 wherein the concentration of the at least one polyoxyethylene sorbitan fatty acid ester is from 0.6 to 0.9 mg/L.

4. Aqueous alkaline pre-treatment solution according to one of the preceding claims
wherein the sulphonated fatty acid is selected from the group consisting of unsaturated branched or unbranched C16 to C20 fatty acids or mixtures thereof.

5. Aqueous alkaline pre-treatment solution according to claim 1 wherein the concentration of the at least one sulphonated fatty acid is from 5 to 10 mg/L, preferably from 6 to 9 mg/L.

6. Aqueous alkaline pre-treatment solution according to one of the preceding claims
wherein the solution has a pH from 8 - 12, preferably from 9.5 to 11.5.

7. Method for pre-treatment of a substrate for subsequent deposition of a palladium activation layer on said substrate in manufacturing an article with an integrated circuit comprising the steps in the following order:
(i) providing the substrate having at least one conductive metal layer surface and at least one non-conductive surface;
(ii) providing the aqueous alkaline pre-treatment solution according to one of the claims 1 to 6;
(iii) treating the substrate with the pre-treatment solution by bringing the substrate into contact with the aqueous pre-treatment solution.

8. Method of claim 7, wherein the method further comprises the step:
(iv) treating the substrate of step (iii) with a palladium activation solution wherein a palladium ion layer is deposited onto the surfaces of the treated substrate of step (iii).

9. Method of claim 8 wherein the method further comprises the step:
(v) treating a substrate of step (iv) with palladium reduction solution wherein the deposited palladium ion layer in step (iv) is transformed into a metallic palladium layer.

10. Method according to one of the claims 7 - 9 wherein the at least one conductive metal layer surface is a copper layer surface.

11. Method according to one of the claims 8 - 10 wherein the palladium ion layer is deposited onto the at least one non-conductive surface of the treated substrate of step (iii).

12. Use of the aqueous pre-treatment solution according to one of the claims 1 to 6 for subsequent deposition of a palladium ion layer on a substrate in manufacturing an article with an integrated circuit wherein the solution is applied directly before applying a palladium activation solution in order to minimize a palladium particle formation while forming the palladium ion layer.

13. Use of the aqueous pre-treatment solution according to one of the claims 1 to 6 or the method according to the claims 7 to 10 for subsequent deposition of a metal layer in manufacturing an article with an integrated circuit.

14. Use of the aqueous pre-treatment solution according to one of the claims 1 to 6 or the method according to one of the claims 7 to 10 for metallization of at least one recessed structure of the at least one non-conductive surface in manufacturing an article with an integrated circuit.

15. Use according to claim 14, wherein the at least one recessed structure is selected from the group consisting of blind micro vias (BMVs), through hole vias (THVs), through glass vias (TGVs), through silicon vias (TSVs), buried vias, and mixtures of any of the aforementioned.

## Patentansprüche

1. Wässrige alkalische Vorbehandlungslösung zum Verwenden vor der Abscheidung einer Palladium-Aktivierungsschicht auf einem Substrat bei der Herstellung eines Gegenstandes mit einer integrierten Schaltung, umfassend:
- mindestens eine Hydroxycarbonsäure oder deren Salz gemäß der allgemeinen Formel (I)
[RCH₂⁻(RCH)ₙ⁻COO⁻]ₘ M^{m+} (I)
wobei n eine ganze Zahl von 2 bis 4 ist und m 1 oder 2 ist,
R unabhängig H oder OH ist, mit der Maßgabe, dass mindestens ein R OH ist, und wobei
M^{m+} mit m: 1 Wasserstoff, Ammonium oder ein Alkalimetall; oder M^{m+} mit m: 2 ein Erdalkalimetall ist, wobei die Konzentration der mindestens einen Hydroxycarbonsäure oder deren Salz 200 bis 400 mg/L beträgt,
- mindestens einen PolyoxyethylenSorbitanfettsäureester, wobei die Konzentration des mindestens einen Polyoxyethylen-Sorbitanfettsäureesters 0,4 bis 1,2 mg/L beträgt,
- mindestens eine sulfonierte Fettsäure oder deren Salz, wobei die Konzentration der mindestens einen sulfonierten Fettsäure von 4 bis 12 mg/L beträgt.

2. Wässrige alkalische Vorbehandlungslösung nach Anspruch 1, wobei die Konzentration der mindestens einen Hydroxycarbonsäure oder ihres Salzes 260 bis 370 mg/L, bevorzugt 280 bis 350 mg/L beträgt.

3. Wässrige alkalische Vorbehandlungslösung nach Anspruch 1, wobei die Konzentration des mindestens einen Polyoxyethylen-Sorbitan-Fettsäureesters 0,6 bis 0,9 mg/L beträgt.

4. Wässrige alkalische Vorbehandlungslösung nach einem der vorhergehenden Ansprüche, wobei die sulfonierte Fettsäure aus der Gruppe ausgewählt ist, die aus ungesättigten verzweigten oder unverzweigten C16- bis C20-Fettsäuren oder deren Mischungen besteht.

5. Wässrige alkalische Vorbehandlungslösung nach Anspruch 1, wobei die Konzentration der mindestens einen sulfonierten Fettsäure 5 bis 10 mg/L, bevorzugt 6 bis 9 mg/L beträgt.

6. Wässrige alkalische Vorbehandlungslösung nach einem der vorhergehenden Ansprüche, wobei die Lösung einen pH-Wert von 8 - 12, vorzugsweise von 9,5 bis 11,5 aufweist.

7. Verfahren zur Vorbehandlung eines Substrats für die anschließende Abscheidung einer Palladium-Aktivierungsschicht auf dem Substrat bei der Herstellung eines Gegenstands mit einer integrierten Schaltung, das die Schritte in der folgenden Reihenfolge umfasst:
(i) Bereitstellen des Substrats, welches mindestens eine leitende Metallschichtoberfläche und mindestens eine nichtleitende Oberfläche aufweist;
(ii) Bereitstellen der wässrigen alkalischen Vorbehandlungslösung nach einem der Ansprüche 1 bis 6;
(iii) Behandeln des Substrats mit der Vorbehandlungslösung durch Inkontaktbringen des Substrats mit der wässrigen Vorbehandlungslösung.

8. Verfahren nach Anspruch 7, wobei das Verfahren ferner den folgenden Schritt umfasst:
(iv) Behandeln des Substrats von Schritt (iii) mit einer Palladiumaktivierungslösung, wobei eine Palladiumionenschicht auf den Oberflächen des behandelten Substrats von Schritt (iii) abgeschieden wird.

9. Verfahren nach Anspruch 8, wobei das Verfahren ferner den folgenden Schritt umfasst:
(v) Behandeln eines Substrats aus Schritt (iv) mit Palladium-Reduktionslösung, wobei die in Schritt (iv) abgeschiedene Palladium-Ionenschicht in eine metallische Palladiumschicht umgewandelt wird.

10. Verfahren nach einem der Ansprüche 7 - 9, wobei die mindestens eine leitende Metallschichtoberfläche eine Kupferschichtoberfläche ist.

11. Verfahren nach einem der Ansprüche 8 - 10, wobei die Palladiumionenschicht auf der mindestens einen nichtleitenden Oberfläche des behandelten Substrats von Schritt (iii) abgeschieden wird.

12. Verwenden der wässrigen Vorbehandlungslösung nach einem der Ansprüche 1 bis 6 zur nachträglichen Abscheidung einer Palladiumionenschicht auf einem Substrat bei der Herstellung eines Gegenstandes mit einer integrierten Schaltung, wobei die Lösung unmittelbar vor dem Aufbringen einer Palladiumaktivierungslösung aufgebracht wird, um eine Palladiumpartikelbildung während der Ausbildung der Palladiumionenschicht zu minimieren.

13. Verwendung der wässrigen Vorbehandlungslösung nach einem der Ansprüche 1 bis 6 oder des Verfahrens nach den Ansprüchen 7 bis 10 zur nachträglichen Abscheidung einer Metallschicht bei der Herstellung eines Gegenstandes mit einer integrierten Schaltung.

14. Verwendung der wässrigen Vorbehandlungslösung nach einem der Ansprüche 1 bis 6 oder des Verfahrens nach einem der Ansprüche 7 bis 10 zur Metallisierung mindestens einer vertieften Struktur der mindestens einen nichtleitenden Oberfläche bei der Herstellung eines Gegenstandes mit einer integrierten Schaltung.

15. Verwendung nach Anspruch 14, wobei die mindestens eine vertiefte Struktur ausgewählt ist aus der Gruppe bestehend aus Blind Microvias (BMVs), Through Hole Vias (THVs), Through Glass Vias (TGVs), Through Silicon Vias (TSVs), Buried Vias und Mischungen aus beliebigen der Vorgenannten.

## Revendications

1. Solution aqueuse alcaline de prétraitement destinée à être utilisée avant le dépôt d'une couche d'activation au palladium sur un substrat dans la fabrication d'un article doté d'un circuit intégré comprenant :
- au moins un acide hydroxycarboxylique ou sel de celui-ci répondant à la formule générale (I)
[RCH₂-(RCH)ₙ-COO⁻]ₘM^{m+} (I),
n étant un nombre entier de 2 à 4 et m valant 1 ou 2,
R étant indépendamment H ou OH à condition qu'au moins un R soit OH et
M^{m+} avec m = 1 étant l'hydrogène, un ammonium ou un métal alcalin ; ou M^{m+} avec m = 2 étant un métal alcalinoterreux, la concentration de l'au moins un acide hydroxycarboxylique ou sel de celui-ci étant de 200 à 400 mg/l,
- au moins un ester d'acide gras et de sorbitane polyoxyéthylénique, la concentration de l'au moins un ester d'acide gras et de sorbitane polyoxyéthylénique étant de 0,4 à 1,2 mg/l,
- au moins un acide gras sulfoné ou un sel de celui-ci, la concentration de l'au moins un acide gras sulfoné étant de 4 à 12 mg/l.

2. Solution aqueuse alcaline de prétraitement selon la revendication 1 dans laquelle la concentration de l'au moins un acide hydroxycarboxylique ou sel de celui-ci est de 260 à 370 mg/l, de préférence de 280 à 350 mg/l.

3. Solution aqueuse alcaline de prétraitement selon la revendication 1 dans laquelle la concentration de l'au moins un ester d'acide gras et de sorbitane polyoxyéthylénique est de 0,6 à 0,9 mg/l.

4. Solution aqueuse alcaline de prétraitement selon l'une des revendications précédentes dans laquelle l'acide gras sulfoné est choisi dans le groupe constitué par des acides gras insaturés en C16 à C20 ramifiés ou non ramifiés ou des mélanges de ceux-ci.

5. Solution aqueuse alcaline de prétraitement selon la revendication 1 dans laquelle la concentration de l'au moins un acide gras sulfoné est de 5 à 10 mg/l, de préférence de 6 à 9 mg/l.

6. Solution aqueuse alcaline de prétraitement selon l'une des revendications précédentes, la solution ayant un pH de 8-12, de préférence de 9,5 à 11,5.

7. Procédé pour le prétraitement d'un substrat pour le dépôt subséquent d'une couche d'activation au palladium sur ledit substrat dans la fabrication d'un article doté d'un circuit intégré comprenant les étapes dans l'ordre suivant :
(i) fourniture du substrat ayant au moins une surface de couche métallique conductrice et au moins une surface non conductrice ;
(ii) fourniture de la solution aqueuse alcaline de prétraitement selon l'une des revendications 1 à 6 ;
(iii) traitement du substrat avec la solution de prétraitement par la mise en contact du substrat avec la solution aqueuse de prétraitement.

8. Procédé selon la revendication 7, le procédé comprenant en outre l'étape :
(iv) traitement du substrat de l'étape (iii) avec une solution d'activation au palladium, une couche d'ions palladium étant déposée sur les surfaces du substrat traité de l'étape (iii).

9. Procédé selon la revendication 8, le procédé comprenant en outre l'étape :
(v) traitement d'un substrat de l'étape (iv) avec de la solution de réduction de palladium, la couche d'ions palladium déposée dans l'étape (iv) étant transformée en une couche de palladium métallique.

10. Procédé selon l'une des revendications 7-9 dans lequel l'au moins une surface de couche métallique conductrice est une surface de couche de cuivre.

11. Procédé selon l'une des revendications 8-10 dans lequel la couche d'ions palladium est déposée sur l'au moins une surface non conductrice du substrat traité de l'étape (iii).

12. Utilisation de la solution aqueuse de prétraitement selon l'une des revendications 1 à 6 pour le dépôt subséquent d'une couche d'ions palladium sur un substrat dans la fabrication d'un article doté d'un circuit intégré dans laquelle la solution est appliquée directement avant l'application d'une solution d'activation au palladium afin de réduire au minimum une formation de particules de palladium pendant la formation de la couche d'ions palladium.

13. Utilisation de la solution aqueuse de prétraitement selon l'une des revendications 1 à 6 ou du procédé selon les revendications 7 à 10 pour le dépôt subséquent d'une couche métallique dans la fabrication d'un article doté d'un circuit intégré.

14. Utilisation de la solution aqueuse de prétraitement selon l'une des revendications 1 à 6 ou du procédé selon l'une des revendications 7 à 10 pour la métallisation d'au moins une structure en creux de l'au moins une surface non conductrice dans la fabrication d'un article doté d'un circuit intégré.

15. Utilisation selon la revendication 14, dans laquelle l'au moins une structure en creux est choisie dans le groupe constitué par des micro-trous d'interconnexion borgnes (BMV), des trous d'interconnexion traversants (THV), des trous d'interconnexion à travers du verre (TGV), des trous d'interconnexion à travers du silicium (TSV), des trous d'interconnexion enterrés et des mélanges de n'importe lesquels de ceux-ci.
